# EUROPÄISCHE PATENTSCHRIFT

(11) **EP 2 252 839 B1**
(45) Veröffentlichungstag und Bekanntmachung des Hinweises auf die Patenterteilung: **16.03.2016**
(21) Anmeldenummer: 09716227.5
(22) Anmeldetag: 04.02.2009
(51) Int. Cl.: F24J 2/00

(54) **THERMISCHE SOLARANLAGE**
THERMAL SOLAR SYSTEM
INSTALLATION SOLAIRE THERMIQUE

(30) Priorität: 29.02.2008 DE 102008011983
(43) Veröffentlichungstag der Anmeldung: 24.11.2010
(73) Patentinhaber: O-Flexx Technologies GmbH, 47059 Duisburg (DE)
(72) Erfinder: BISGES, Michael, 93161 Sinzing (DE)
(74) Vertreter: Kohlmann, Kai
(86) Internationale Anmeldenummer: PCT/EP2009/051222
(87) Internationale Veröffentlichungsnummer: WO 2009/109440

(56) Entgegenhaltungen:
- DE-A1- 3 514 490
- DE-A1- 3 704 559
- DE-A1- 10 122 679
- DE-U1-202005 002 198
- GB-A- 2 172 394

## Beschreibung

Die Erfindung betrifft eine thermische Solaranlage mit einem Kollektor, der über einen ein Wärmeträgermedium enthaltenden Solarkreislauf mit einer Wärmesenke verbunden ist.

Als thermische Solaranlage werden Solaranlagen bezeichnet, die Wärme aus der Sonneneinstrahlung nutzbar machen (Solarthermie). Die Wärme wird insbesondere in der Gebäudetechnik oder in thermischen Solarkraftwerken zur Stromerzeugung nutzbar gemacht. Die direkte Umwandlung von Sonnenlicht in Strom wird dagegen als Photovoltaik, die entsprechenden Anlagen als Photovoltaikanlagen bezeichnet.

Bei der Wärmegewinnung wird der Absorber eines thermischen Kollektors durch die Sonnenenergie erhitzt. Durch den Kollektor strömt ein Wärmeträgermedium, das die Wärme aufnimmt. Eine Pumpe fördert das Wärmeträgermedium in einem Solarkreislauf, über den die Wärme vom Kollektor in eine Wärmesenke, insbesondere den Solarwärmespeicher verbracht wird; der Solarwärmespeicher, nimmt Wärme auf und speichert sie.

Der Kollektor ist der Teil der Solaranlage, der die Wärme der Sonne aufnimmt und die absorbierte Wärme möglichst verlustfrei auf das Wärmeträgermedium im Solarkreislauf überträgt.

Die wichtigste bautechnische Unterscheidung bei Kollektoren ist die zwischen Flachkollektoren und Röhrenkollektoren. Technisch unterscheiden sich die Flach- und Röhrenkollektoren durch die Isolierung des Absorbers. Die Isolationswirkung wird bei Vakuumröhrenkollektoren durch ein Vakuum in einer Glasröhre erreicht, welches einen Wärmetransport durch Konvektion vollständig unterbindet.

Flachkollektoren nutzen herkömmliche Isoliermaterialien, zum Beispiel Mineralwolle oder Polyurethan-Schaum. Diese Isolierung ist weniger effizient als ein Vakuum, daher werden größere Kollektorflächen benötigt um vergleichbare Leistungswerte zu erreichen. Heutige Hochleistungs-Flachkollektoren arbeiten mit einem Kupferabsorber. Da Flachkollektoren jedoch deutlich preisgünstiger und damit in der Regel wirtschaftlicher sind als Vakuumröhrenkollektoren, wird in der Haustechnik überwiegend dieser Bautyp eingesetzt.

Von herkömmlichen Brauchwassertanks unterscheiden sich SolarWärmespeicher vor allem durch eine sehr starke Isolierung, eine hohe und schlanke Bauform des Wasserbehälters, die die Entwicklung unterschiedlicher Temperaturschichten erlaubt (oben heißes Wasser, unten kühles Wasser), sowie einen tief angebrachten, großflächigen Wärmeüberträger für die Übertragung der Wärme aus dem Solarkreislauf.

Sobald die Temperatur im Kollektor um eine festgelegte Temperaturdifferenz über der Temperatur am Solarwärmeüberträger liegt, wird von einer Steueranlage die Pumpe gestartet und die Wärme in den Solarwärmespeicher transportiert; sobald die Temperaturdifferenz zwischen Kollektor und Speicher den Grenzwert unterschreitet, wird die Anlage gestoppt.

Handelsübliche Kollektoren können 60 bis 70 Prozent der auf die Köllektorfläche auftreffenden Sonnenenergie in nutzbare Wärme umwandeln. In diesen Kollektoren wird meist ein WasserPropylenglykol-Gemisch (Verhältnis 60:40) als Wärmeträgermedium verwendet. Durch den Zusatz von 40 Prozent Propylenglykol wird ein Frostschutz bis -23 °C, darunter ein Gefrieren ohne Frostsprengung sowie eine Siedetemperatur, die je nach Druck 150 °C und mehr betragen kann, erreicht. Bei höheren Temperaturen gehen viele Kollektoren in Stillstand und liefern keine Energie mehr.

Außerhalb der Heizperiode werden thermische Solaranlagen vielfach nur zur Warmwassererwärmung genutzt. Hieraus resultiert eine geringere Gesamteffizienz der Anlage. Im Stillstand der Anlage besteht die Gefahr der Überhitzung und damit der Beschädigung der thermischen Solaranlage.

Aus der GB 2 172 394 A ist ein Stromerzeuger mit einem Flachbett-Sonnenkollektor und einer thermoelektrischen Zelle bekannt, an deren heißer Seite ein Heißwasservorrat und an deren kalter Seite ein Kaltwasservorrat gekoppelt ist, die wahlweise über Ventile mit dem Flachbett-Sonnenkollektor verbindbar sind. In einer Wüstenregion zirkuliert tagsüber das Wasser zwischen dem Flachbett-Sonnenkollektor und dem Heißwasservorrat und nachts zwischen dem Flachbett-Sonnenkollektor und dem Kaltwasservorrat, der die während des Tages aufgenommene Wärme wieder an die kühlere Umgebung abgibt.

Aus der DE 35 14 490 A1 ist eine Anordnung zum Betrieb einer Peltier-Wärmepumpe bekannt, die einen Sonnenkollektor umfasst, dessen Wärmeträgermedium einen Wärmetauscher einer Peltier-Batterie durchfließt. Dabei wird der Wärmetauscher mittels Ventilsteuerung wahlweise mit dem Sonnenkollektor oder einem Erdreichkollektor verbunden. Die Peltier-Batterie ist auf Seiten einer Wärmesenke in Form eines Pufferspeichers mit einem weiteren Wärmetauscher verbunden. Die zwischen den beiden Wärmetauschern angeordnete Peltier-Batterie wird von einer Spannungsquelle mit Strom versorgt und arbeitet als Peltier-Wärmepumpe.

Ausgehend von diesem Stand der Technik liegt der Erfindung daher die Aufgabe zu Grunde, eine thermische Solaranlage zu schaffen, bei der die Gefahr der Überhitzung reduziert und die Effizienz der Solaranlage, insbesondere auch außerhalb der Heizperiode, verbessert wird.

Die Lösung dieser Aufgabe beruht auf dem Gedanken eine thermische Solaranlage derart mit einem elektrischen Thermogenerator zu verbinden, dass die ungenutzte Wärme des Kollektors zur Energieerzeugung in einem Thermogenerator, insbesondere im Leerlauf des Kollektors, genutzt werden kann.

Im Einzelnen wird die Aufgabe bei einer thermischen Solaranlage der eingangs erwähnten Art durch die Kennzeichnenden Merkmale des Anspruchs 1 gelöst.

Zur Auskopplung der überschießenden Wärme aus dem Solarkreislauf ist dieser mittels der Ventilsteuerung zeitweilig, insbesondere in der Leerlaufphase der thermischen Solaranlage, mit dem Wärmetauscher verbindbar, der an der heißen Seite des Thermoelementes angeordnet ist. Die Wärmedämmung zwischen dem Kollektor und dem Wärmetauscher verhindert weitgehend, dass dem Kollektor in der Leistungsphase, das heißt wenn der maximale Wärmestrom der Wärmesenke, insbesondere dem Wärmespeicher zugeführt werden soll, Wärme entzogen und an den Thermogenerator abgegeben wird.

Unter Wärmedämmung sind im Sinne der Erfindung Maßnahmen zur Eindämmung der Abgabe thermischer Energie von dem Kollektor der thermischen Solaranlage an den dem Thermogenerator zugeordneten Wärmetauscher zu verstehen.

Der Begriff Kollektor im Sinne der Erfindung umfasst eine Anordnung aus einem oder mehreren Sonnenkollektoren (z.B. Flachkollektoren und Röhrenkollektoren), die hintereinander und/oder parallel zueinander geschaltet sein können.

Ein derartiger Kollektor ist über den Solarkreislauf mit der Wärmesenke verbunden. Als Wärmesenke kommen insbesondere Wärmespeicher in Betracht, um die von den Kollektoren aufgenommene Wärme unabhängig von der aktuellen Sonneneinstrahlung nutzen zu können. Denkbar ist es jedoch auch, die von den Kollektoren aufgenommene Wärme über den Solarkreislauf unmittelbar einem als Wärmesenke wirkenden Verbraucher zuzuführen.

Wird der plattenförmige Wärmetauscher mit dem Thermogenerator flächig an der passiven ebenen Rückseite des Kollektors angeordnet, befindet sich zwischen dem Kollektor und dem Wärmetauscher als Wärmedämmung eine wärmedämmende Zwischenschicht aus Dämmstoff, insbesondere geschäumten Kunststoffen oder Mineralwolle.

Sofern die Platzverhältnisse dies erlauben, kann der plattenförmige Wärmetauscher mit dem Thermogenerator als von dem Kollektor separate Baueinheit ausgeführt sein. In diesem Fall stellt der Abstand zwischen dem Kollektor und dem plattenförmigen Wärmetauscher sicher, dass während der Leistungsphase des Kollektors nahezu keine Wärme im Wege der Konvektion auf den Wärmetauscher übergeht und in Folge dessen der gesamte Wirkungsgrad der thermischen Solaranlage sinkt. Die Ausführung als separate Baueinheit bietet darüber hinaus den Vorteil, dass an der heißen Seite des Thermogenerators ein Absorber zur Aufnahme der Energie der einfallenden Sonneneinstrahlung angeordnet werden kann, der zusätzliche Energie in die Solaranlage einbringt, die entweder vollständig zur Erzeugung von elektrischem Strom genutzt wird oder teilweise in den Solarkreislauf zur Aufheizung des Wärmespeichers genutzt wird.

Für den zuletzt genannten Hybridbetrieb ist es erforderlich, dass die Ventilsteuerung Stetigventile aufweist, die eine Einstellung des Volumenstroms des Wärmeträgermediums in dem Solarkreislauf sowie dem Wärmetauscher erlauben.

In einer einfacheren Ausgestaltung der thermischen Solaranlage, ist der Kollektor wahlweise mit dem Wärmespeicher oder dem Wärmetauscher des Thermogenerator mit Hilfe mindestens eines Mehr-Wegeventils verbindbar.

Ist mindestens je ein drei/zwei - Wegeventil in den vorlauf und den Rücklauf geschaltet, kann der Wärmetauscher des Thermogenerators von dem Solarkreis vollständig entkoppelt werden.

Die Freigabe des Durchflussweges von dem Kollektor zum Thermogenerator erfolgt insbesondere im Leerlauf, das heißt bei vollständig aufgeheiztem Wärmespeicher, um eine Überhitzung und damit Beschädigung der thermischen Solaranlage zu verhindern. Im Leerlauf wird der gesamte Wärmestrom von dem Kollektor zu dem Wärmetauscher geleitet und in dem angekoppelten Thermogenerator teilweise in elektrische Energie gewandelt. Während der Aufheizung des Wärmespeichers wird indes keine Wärmeenergie zum Thermogenerator geführt.

Die Ventile bzw. das Ventil der Ventilsteuerung können von Hand betätigt werden. Vorzugsweise handelt es sich jedoch um elektrische betätigte Mehrwege-Ventile oder Stetig-Ventile, die von der ohnehin vorhandenen Steuerung der Solaranlage betätig werden, die aufgrund ihrer Messfühler einen Leerlauf der thermischen Solaranlage erkennt und in Folge dessen den Schaltbefehl für jedes Ventil auslöst. Für den komplexeren Hybrid-Betrieb verzweigt die Steuerung über mindestens ein Stetig-Ventil das Wärmeträgermedium bedarfsgerecht auf den Wärmespeicher einerseits und den Thermogenerator andererseits unter Berücksichtigung des Wärmeabflusses aus dem Wärmespeicher sowie der Intensität und Dauer der Sonneneinstrahlung auf den Kollektor.

Ein als Thermogenerator betriebenes Thermoelement liefert nach dem Seebeck-Effekt elektrische Spannung. Meist wird eine größere Anzahl von Thermopaaren zu einem Thermoelement zusammengeschaltet. Der Thermogenerator kann eines oder mehrere Thermoelemente umfassen, die elektrisch hintereinander und/oder parallel geschaltet sind. Die in den Thermoelementen genutzte Thermospannung ist temperaturabhängig und bewegt sich in einem Bereich von wenigen Mikrovolt. Es halben sich einige Legierungen durch ihre Eigenschaften bei bestimmten Temperaturen als Thermopaare durchgesetzt und sich somit eine Palette von Thermomaterialkombinationen (Thermopaare) über einen Temperaturbereich von -270°C bis 2600°C gebildet. Diese Palette wurde in Normen erfasst und definiert. Die derzeit gültige internationale Norm für Thermoelemente ist die IEC 584-1, das Pendant im deutschsprachigen Raum die DIN EN 60584 Teil 1. Diese Norm definiert 10 verschiedene Thermomaterialkombination in ihren Eigenschaften.

| Typ/Kennbuchstabe | Legierung |
|---|---|
| K | Nickel-Chrom / Nickel-Aluminium |
| T | Kupfer / Kupfer-Nickel |
| J | Eisen / Kupfer-Nickel |
| N | Nickel-Chrom-Silizium / Nickel-Silizium |
| E | Nickel-Chrom / Kupfer-Nickel |
| R | Platin-13%Rhodium / Platin |
| S | Platin-10%Rhodium / Platin |
| B | Platin-30%Rhodium / Platin |

Eine weitere in Deutschland noch angewendete Norm ist die DIN 43710, welche die Thermotypen U und L definiert. Diese Norm ist aber nicht mehr gültig.

| | |
|---|---|
| U | Kupfer / Kupfer-Nickel |
| L | Eisen / Kupfer-Nickel |

Neben den genormten Thermopaaren gibt es noch andere Kombination mit speziellen Eigenschaften. Ein Beispiel sind hier die Wolfram/Wolfram-Rhenium Kombination mit möglichen Temperaturbereichen bis 2600 °C.

Als leitfähige Materialien für Thermopaare von Thermoelementen kommen insbesondere auch p- und n- dotierte Halbleitermaterialen, meist Wismut-Tellurit, Bi₂Te₃ in Betracht. Außerdem kommen die in den nachfolgenden Tabellen 1.1. und 1.2 genannten p- und n-dctierten Verbindungen in Betracht:

**Tabelle 1.1: Die p-Typ Verbindungen mit den besten thermoelektrischen Eigenschaften.**

| T [K] | Verbindung p-Typ | Z [1/K] |
|---|---|---|
| 225 | CsBi₄Te₆ : Sbl₃ (0,05%) | 3,5-10⁻³ |
| 300 | (Sb₂Te₃)₇₂Bi₂Te₃)₂₅(S ₂Se₃)₃ | 3,4-10⁻³ |
| 500 | Tl₉BiTe₆ | 2,3-10⁻³ |
| 700 | GeTe₁₋ₓ(AgSbTe₂)ₓ | 3,0-10⁻³ |
| 1200 | Si_{0,85}Ge_{0,15} : B | 6,7-10⁻⁴ |

**Tabelle 1.2: die n-Typ Verbindungen mit den besten thermoelektrischen Eigenschaften.**

| T [K] | Verbindung n-Typ | Z [1/K] |
|---|---|---|
| 80 | Bi_{0,85}Sb_{0,15} | 6,5-10⁻³ |
| 300 | ((Sb₂Te₃)₅Bi₂Te₃)₉₀( Sb₂ Se₃)₅ | 3,2-10⁻³ |
| 450 | Bi₂Te_{2,7}Se_{0,3} | 2,8-10⁻³ |
| 800 | Pb_{0,75}Sn_{0,25}Se | >1,25-10⁻³ |
| 1200 | Si_{0,85}Ge_{0,15} : P | 8,3-10⁻⁴ |

Ein als Thermogenerator betriebenes Thermoelement besteht üblicherweise aus zwei dünnen wärmeleitenden, insbesondere keramischen Platten zwischen denen abwechselnd kleine Quader aus unterschiedlich leitendem Material, insbesondere Halbleitermaterial, eingelötet sind. Jeweils zwei unterschiedliche Quader sind so miteinander verbunden, dass sie eine Reihenschaltung ergeben. Eine der beiden Platten nimmt den einfließenden Wärmestrom auf (nachfolgend auch als heiße Seite des Thermoelementes bezeichnet), während die andere Platte den ausfließenden Wärmestrom abgibt(nachfolgend auch als kalte Seite des Thermoelementes bezeichnet).

Neben den herkömmlichen zwischen Platten angeordneten Thermoelementen können insbesondere auch Dünnschicht-Thermoelemente zum Einsatz gelangen, wie sie beispielsweise aus der DE 101 22 679 A1, bekannt sind.

Um die für die Wärmeabgabe des Thermogenerators zur Verfügung stehende Fläche auf dessen kalter Seite zu vergrößern, kann der Thermogenerator einen Kühlkörper, insbesondere mit einer Rippenstruktur aufweisen. Die Rippen der Rippenstruktur erstrecken sich von der kalten Seite vorzugweise in senkrechter Richtung. Durch die infolge der Rippen verbesserte Wärmeabfuhr wird der Wirkungsgrad des Thermogenerators verbessert.

Wenn außerdem die den einfließenden Wärmestrom aufnehmende heiße Seite jedes Thermogenerators unmittelbar an dem Wärmetauscher vollflächig anliegt, wird der Wirkungsgrad weiter verbessert. Die Verbesserung resultiert im wesentlichen aus der insgesamt größeren Fläche für den Wärmeübergang in die heiße Seite des Thermogenerators.

Nachfolgend wird die Erfindung anhand von Ausführungsbeispielen näher erläutert. Es zeigen
- **Figur 1**: ein erstes Ausführungsbeispiel einer erfindunggemäßen thermischen Solaranlage mit bauseitig integriertem Thermogenerators sowie
- **Figur 2**: ein zweites Ausführungsbeispiel einer erfindunggemäßen thermischen Solaranlage mit bauseitig separatem Thermogenerator.

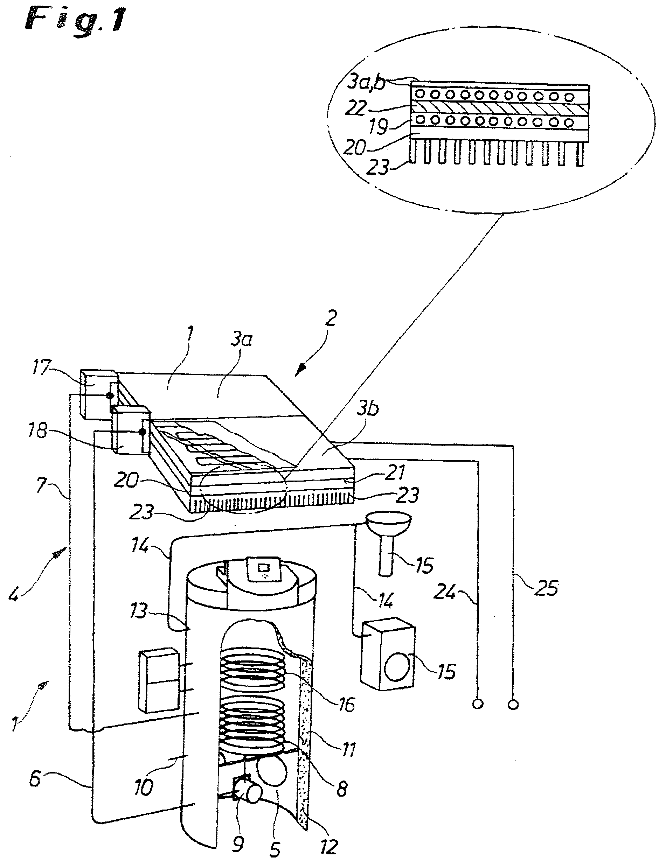

Figur 1 zeigt eine insgesamt mit (1) bezeichnete thermische Solaranlage mit einem Kollektor (2), der aus zwei hintereinander geschalteten Flachbettkollektoren (3a, 3b) besteht. Der Kollektor (2) ist über einen Solarkreislauf (4) mit einem Wärmespeicher (5) verbunden. Der Solarkreislauf (4) besteht aus einem Vorlauf (7), einem Rücklauf (6) sowie einem in dem Wärmespeicher (5) angeordneten Rohrwärmetauscher (8). Ferner befindet sich am Ende des Rücklaufs (6) eine Pumpe (9), die das Wärmeträgermedium in dem Solarkreislauf (4) sowie dem Kollektor (2) zirkulieren lässt. Der Wärmespeicher (5) ist im dargestellten Ausführungsbeispiel als hohlzylindrischer Solartank ausgeführt. Als Speichermedium dient Wasser, das über den Zulauf (10) dem Wärmespeicher zugeführt wird. Der teilweise im Schnitt dargestellte Mantel (11) des Wärmespeichers weist eine aufwendige Wärmedämmung (12) auf, um die Wärmeverluste zu reduzieren. Die hohe und schlanke Bauform des Wärmespeichers erlaubt die Ausbildung unterschiedlicher Temperaturschichten. Im oberen Teil des Behälters befindet sich heißes, unten kühleres Wasser. Der im unteren Behälterteil angebrachte Rohrwärmetauscher (8) dient der Übertragung der Wärme aus dem Solarkreislauf (4) auf das Wasser in Wärmespeicher. Die Entnahmestelle (13) im oberen Behälterteil des Wärmespeichers (5) ist über Rohrleitungen (14) mit Warmwasserverbrauchern (15) verbunden. Ferner ist in dem Wärmespeicher (5) ein weiterer Wärmetauscher (16) angeordnet, der in den Heizkreislauf eingebunden ist. An den Anschlüssen von Vcr- und Rücklauf (6, 7) an dem Kollektor (2) befindet sich jeweils ein Mehr-Wegeventil (17, 18), wobei in einer ersten Schaltstellung der beiden Mehr-Wegeventile (17, 18) deren Anschlüsse den Durchflussweg von dem Kollektor (2) zum Wärmespeicher (5) und in einer zweiten Schaltstellung der beiden Mehr-Wegeventile (17, 18) deren Anschlüsse den Durchflussweg von dem Kollektor (2) zum Wärmetauscher (19) eines Thermogenerators (20) freigeben, so dass das Wärmeträgermedium hintereinander sowohl den Kollektor (2) als auch den Wärmetauscher (19) durchströmt. In dieser Schaltstellung der Mehr-Wegeventile (17,18) ist das Rohrssystem des Kollektors (2) mit dem Wärmetauscher (19) in Reihe geschaltet, Grundsätzlich ist in dieser Schaltstellung sowohl der Kollektor (2) als auch der Wärmetauscher (19) in den Solarkreislauf (4) zum Wärmespeicher eingebunden. Ist jedoch zwischen Kollektor (2) und Wärmetauscher (19) ein zusätzliches Fördermittel (z.B. eine Pumpe) angeordnet, können der Kollektor (2) und Wärmetauscher (19) von dem Solarkreislauf (4) entkoppelt werden. Der plattenförmige Wärmetauscher (19) ist an einer einen einfließenden Wärmestrom aufnehmenden heißen Seite des Thermogenerators (20) angeordnet. Der Wärmetauscher (19) ist flächig, unter Ausbildung eines Schichtaufbaus, an der passiven Rückseite (21) des Kollektors (2) angeordnet, wobei sich zur thermischen Entkopplung zwischen dem Kollektor (2) und dem Wärmetauscher (19) eine wärmedämmende Zwischenlage (22) befindet. An der dem Wärmetauscher (19) gegenüberliegenden kalten Seite des Thermogenerators (20) ist ein Rippen-Kühlkörper (23) angeordnet, der die Temperaturdifferenz zwischen der heißen und kalten Seite des Dünnschicht-Thermoelemente aufweisenden Thermogenerators (20) und damit dessen Wirkungsgrad erhöht.

Der Thermogenerator (20) ist über zwei nicht dargestellte Kontaktstellen mit elektrischen Leitungen (24, 25) verbunden, über die die elektrische Energie von dem thermoelektrischen Generator (20) abgeführt wird.

Die thermische Solaranlage (1) arbeitet wie folgt:

Sobald der Wärmespeicher (5) vollständig aufgeheizt ist geht die thermische Solaranlage (1) in den Leerlaufbetrieb. In diesem Fall kann der Solarkreislauf (4) mittels der beiden Mehr-Wegeventile (17, 18) unterbrochen und die von dem Kollektor (2) gesammelte Wärme dem Wärmetauscher (19) des Thermogenerators (20) zugeführt werden. In diesem Fall ist der Rohrwärmetauscher(8) und in Folge dessen der Wärmespeicher (5) von dem Kollektor (2) entkoppelt und der vollständige Wärmestrom wird dem Wärmetauscher (19) zugeführt. In diesen Fall muss das bereits erwähnte Fördermittel vorgesehen werden.

Alternativ wird bei überschüssiger Wärme im Kollektor (2) mittels der Mehr-Wegeventile (17,18) das Rohrsystem des Kollektors (2) mit dem Wärmetauscher (19) in Reihe geschaltet. Die Reihenschaltung aus Kollektor (2) und Wärmetauscher (19) ist in den Solarkreislauf (4) zum Wärmespeicher eingebunden, so dass überschüssige Wärmeenergie zur Erzeugung von elektrischem Strom im Thermogenerator zur Verfügung steht.

Wird die in dem Kollektor (2) anfallende Wärmeenergie wieder vollständig zur Aufheizung des Wärmespeichers (5) benötigt, wird der Solarkreislauf (4) über die Mehr-Wegeventile (17, 18) mit dem Rohrwärmetauscher (8) in dem Wärmespeicher (5) verbunden und der Wärmetauscher (19) des Thermogenerators (20) von den Kollektoren (2) vollständig entkoppelt. In diesem Betriebsmodus steht die gesamte Wärmeenergie zur Aufheizung des Wärmespeichers (5) zur Verfügung. Die wärmedämmende Zwischenlage (22) verhindert weitgehend eine Wärmekonvektion zwischen dem Kollektor (2) und dem Thermogenerator (20), obwohl beide Elemente platzsparend zu einer Baueinheit zusammengefasst sind.

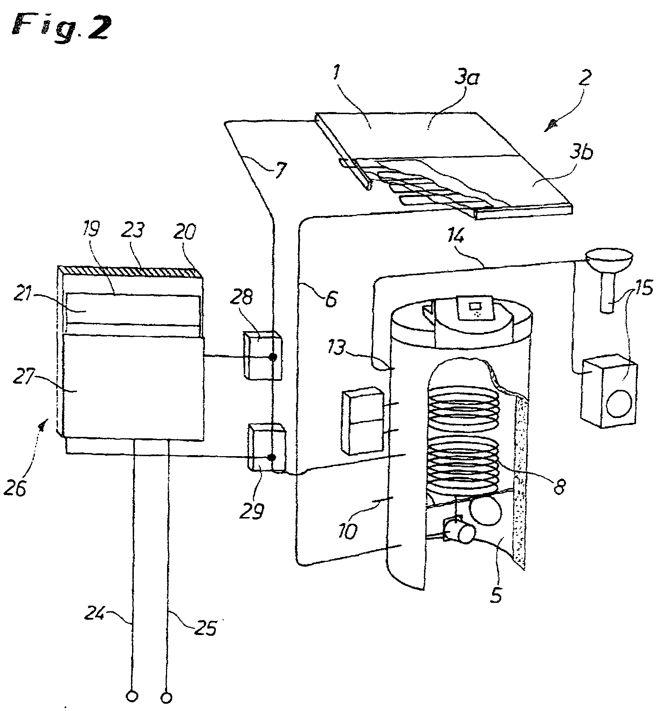

Die thermische Solaranlage nach Figur 2 unterscheidet sich im Wesentlichen dadurch, dass der plattenförmige Wärmetauscher (19) und der Thermogenerator (20) als von dem Kollektor (2) separate Baueinheit (26) ausgeführt sind. Diese Baueinheit (26) ist im Abstand von dem Kollektor (2), zum Beispiel an der senkrechten Fassade eines Hauses angeordnet, während der Kollektor (2) auf dessen Dach installiert wird. Die Vorderseite des Thermogenerators (20) ist in dieser Ausführung der Erfindung zusätzlich nit einem Absorberblech (27) ausgestattet, so dass zusätzliche Energie in die heiße Seite des Thermogenerators (20) oder überschüssige, nicht zur Erzeugung von Thermoelektrizität benötigte Energie in den Solarkreislauf (4) eingespeist wird. Der Wärmetauscher (19) kann allein mit Hilfe des Drei-/Zweiwegeventils (28) mit dem Kollektor(2) in Reihe geschaltet werden, so dass der Wärmetauscher (19) Bestandteil des Solarkreislaufs (4) wird. Das weitere Drei/Zweiwegeventils (29) dient der vollständigen Entkopplung des Wärmetauschers (19), wenn die in dem Kollektor (2) anfallende Wärmeenergie vollständig zur Aufheizung des Wärmespeichers (5) benötigt wird. Grundsätzlich kann auf dieses Ventil jedoch auch verzichtet werden.

Schließlich kann die Ventilsteuerung Stetigventile aufweisen, die eine Einstellung des Volumenstroms des Wärmeträgermediums ermöglichen. In einem Hybridbetrieb des Wärmespeichers (5) sowie des Thermogenerators (20) kann die auf den Absorber (19) des Thermogenerators (20) sowie die auf den Kollektor (2) auftreffende Sonnenenergie bedarfsgerecht auf den Thermogenerator (20) einerseits und den Wärmespeicher (5) andererseits verteilt werden.

| **Bezugszeichenliste** | |
|---|---|
| Nr. | Bezeichnung |
| 1. | thermische Solaranlage |
| 2. | Kollektor |
| 3a, b | Flachbettkollektoren |
| 4. | Solarkreislauf |
| 5. | Wärmespeicher |
| 6. | Vorlauf |
| 7. | Rücklauf |
| 8. | Rohrwärmetauscher |
| 9. | Pumpe |
| 10. | Zulauf |
| 11. | Mantel |
| 12. | Wärmedämmung |
| 13. | Entnahme |
| 14. | Rohrleitungen |
| 15. | Warmwasserverbrauchern |
| 16. | Wärmetauscher |
| 17. | Mehr-Wegeventil |
| 18. | Mehr-Wegeventil |
| 19. | Wärmetauscher |
| 20. | Thermogenerator |
| 21. | passive Rückseite |
| 22. | Zwischenlage |
| 23. | Rippen-Kühlkörper |
| 24. | elektrische Leitung |
| 25. | elektrische Leitung |
| 26. | Baueinheit |
| 27. | Absorberblech |
| 28. | |

## Patentansprüche

1. Thermische Solaranlage mit einem Kollektor, der über einen ein Wärmeträgermedium enthaltenden Solarkreislatf mit einer Wärmesenke, insbesondere einem Wärmespeicher (5) ver-bunden ist, **dadurch gekennzeichnet, dass** der Solarkreislauf (4) mittels einer Ventilsteuerung (17,18) zur Auskopplung überschießender Wärme aus dem Solarkreislauf zeitweilig mit mindestens einem von dem Wärmeträgermedium durchströmbaren Wärmetauscher (19) verbindbar ist, der an einer einen einfließenden Wärmestrom aufnehmenden heißen Seite eines Thermogenerators (2C) angeordnet ist und zwischen dem Kollektor (2) der thermisehen Solaranlage (1) und dem mindestens einen Wärmetauscher (19) eine Wärmedämmung (22) den Austausch von Wärmeenergie verringert.

2. Thermische Solaranlage nach Anspruch 1, **dadurch gekennzeichnet, dass** der Thermogenerator (20) mindestens ein Dünnschicht-Thermoelement aufweist.

3. Thermische Solaranlage nach Anspruch 1 oder 2, **dadurch gekennzeichnet, dass** der mindestens eine Wärmetauscher plattenförmig ausgebildet ist und dass der mindestens eine Wärmetauscher (19) und der Thermogenerator (20) flächig an der passiven Rückseite (21) des Kollektors (2) angeordnet sind und sich zwischen dem Kollektor (2) und dem mindestens einen Wärmetauscher (19) eine wärmedämmende Zwischenschicht (22) befindet.

4. Thermische Solaranlage nach Anspruch 1 oder 2, **dadurch gekennzeichnet, dass** der mindestens eine Wärmetauscher plattenförmig ausgebildet ist und dass der mindestens eine Wärmetauscher (19) und der Thermogenerator (20) als von dem Kollektor (2) separate Baueinheit (26) ausgeführt sind.

5. Thermische Solaranlage nach Anspruch 4, **dadurch gekennzeichnet, dass** die Baueinheit (26) im Abstand von dem Kollektor (2) angeordnet ist.

6. Thermische Solaranlage nach einem der Ansprüche 1 bis 4, **dadurch gekennzeichnet, dass** der mindestens eine Wärmetauscher (19) ein Plattenwärmetauscher oder ein Rohrwärmetauscher ist.

7. Thermische Solaranlage, nach einem der Ansprüche 1 bis 6, **dadurch gekennzeichnet, dass** an der kalten Seite des Thermogenerators (20) ein Kühlkörper (23) angeordnet ist.

8. Thermische Solaranlage nach einem der Ansprüche 5 bis 7, **dadurch gekennzeichnet, dass** an der heißen Seite des Thermogenerators (20) ein Absorber (27) zur Aufnahme der Energie der einfallenden Sonnenstrahlung angeordnet ist.

9. Thermische Solaranlage nach einem der Ansprüche 1 bis 8, **dadurch gekennzeichnet, dass** die Ventilsteuerung mindestens ein Mehr-Wegeventil (17, 18, 28, 29) umfasst.

10. Thermische Solaranlage nach Anspruch 9, **dadurch gekennzeichnet, dass** in mindestens einer Schaltstellung des mindestens einen Mehr-Wegeventils (28, 17) der Kollektor (2) zeitweilig mit dem mindestens einen Wärmetauscher (19) verbindbar ist.

11. Thermische Solaranlage nach einem der Ansprüche 1 bis 9, **dadurch gekennzeichnet, dass** der Solarkreislauf (4) einen Vorlauf (7) und einen Rücklauf (6) zwischen dem Kollektor (2) und einer als Wärmespeicher (5) ausgebildeten Wärmesenke aufweist und zumindest ein Stetigventil in den Vorlauf (7) geschaltet ist, das eine Einstellung des Volumenstroms des Wärmeträgermediums von dem Kollektor (2) zum Solarkreislauf (4) sowie zum Wärmetauscher (19) erlaubt.

12. Thermische Solaranlage nach Anspruch 10 oder 11, **dadurch gekennzeichnet, dass** jedes Mehrwege-Ventil oder Stetig-ventil elektrisch betätigbar und mit der Steuerung der Solaranlage verbunden ist.

## Claims

1. A thermal solar system comprising a collector which is connected to a heat sink, in particular a heat storage device (5) via a solar circuit containing a heat transfer medium, **characterized in that** the solar circuit (4) can be temporarily connected to at least one heat exchanger (19) through which heat transfer medium can flow, by means of a valve control system (17, 18) for coupling out excess heat from the solar circuit, which heat exchanger (19) is arranged on a hot side of a thermogenerator (20) that receives an incoming heat flow and a thermal insulation (22) between the collector (2) of the thermal solar system (1) and the at least one heat exchanger (19) reduces the exchange of thermal energy.

2. The thermal solar system according to claim 1, **characterized in that** the thermogenerator (20) comprises at least one thin-film thermocouple.

3. The thermal solar system according to claim 1 or 2, **characterized in that** the at least one heat exchanger is configured in a plate shape and that the at least one heat exchanger (19) and the thermogenerator (20) are arranged flat on the passive rear side (21) of the collector (2) and a heat-insulating intermediate layer (22) is located between the collector (2) and the at least one heat exchanger (19).

4. The thermal solar system according to claim 1 or 2, **characterized in that** the at least one heat exchanger is configured in a plate shape and that the at least one heat exchanger (19) and the thermogenerator (20) are designed as a structural unit (26) separate from the collector (2).

5. The thermal solar system according to claim 4, **characterized in that** the structural unit (26) is located at a distance from the collector (2).

6. The thermal solar system according to any one of claims 1 to 4, **characterized in that** the at least one heat exchanger (19) is a plate heat exchanger or a tubular heat exchanger.

7. The thermal solar system according to any one of claims 1 to 6, **characterized in that** a cooling element (23) is arranged on the cold side of the thermogenerator (20).

8. The thermal solar system according to any one of claims 5 to 7, **characterized in that** an absorber (27) for receiving the energy of the incoming solar radiation is arranged on the hot side of the thermogenerator (20).

9. The thermal solar system according to any one of claims 1 to 8, **characterized in that** the valve control system comprises at least one multi-way valve (17, 18, 28, 29).

10. The thermal solar system according to claim 9, **characterized in that** in at least one switch position of the at least one multi-way valve (28, 17), the collector (2) can be connected temporarily to the at least one heat exchanger (19).

11. The thermal solar system according to any one of claims 1 to 9, **characterized in that** the solar circuit (4) has a forward flow line (7) and a return line (6) between the collector (2) and a heat sink configured as a heat storage device (5), and at least one proportional valve is connected in the forward flow line (7) which allows an adjustment of the volume flow of the heat transfer medium from the collector (2) to the solar circuit (4) and to the heat exchanger (19).

12. The thermal solar system according to any one of claims 10 or 11, **characterized in that** each multi-way valve or proportional valve can be actuated electrically and connected to the control unit of the solar system.

## Revendications

1. Installation solaire thermique avec un collecteur, qui par l'intermédiaire d'un circuit solaire contenant un milieu caloporteur est relié avec un dissipateur thermique, notamment un accumulateur de chaleur (5), **caractérisée en ce que**, pour découpler de la chaleur excessive, le circuit solaire (4) peut être relié temporairement au moyen d'une commande par soupapes (17, 18) avec au moins un échangeur thermique (19) pouvant être irrigué par le milieu caloporteur, qui est placé sur un côté chaud d'un thermogénérateur (20) absorbant un flux de chaleur entrant et entre le collecteur (2) de l'installation solaire thermique (1) et l'au moins un échangeur thermique (19), une isolation thermique (22) réduit l'échange d'énergie thermique.

2. Installation solaire thermique selon la revendication 1, **caractérisée en ce que** le thermogénérateur (20) comporte au moins un thermocouple à couche mince.

3. Installation solaire thermique selon la revendication 1 ou 2, **caractérisée en ce que** l'au moins un échangeur thermique (19) et le thermogénérateur (20) sont placés à plat sur la face arrière (21) passive du collecteur (2) et entre le collecteur (2) et l'au moins un échangeur thermique (19) se trouve une couche intermédiaire (22) d'isolation thermique.

4. Installation solaire thermique selon la revendication 1 ou 2, **caractérisée en ce que** l'au moins un échangeur thermique est conçu en forme de plaque et **en ce que** l'au moins un échangeur thermique (19) et le thermogénérateur (20) sont conçus sous la forme d'une unité modulaire (26) séparée du collecteur (2).

5. Installation solaire thermique selon la revendication 4, **caractérisée en ce que** l'unité modulaire (26) est placée avec un écart par rapport au collecteur (2).

6. Installation solaire thermique selon l'une quelconque des revendications 1 à 4, **caractérisée en ce que** l'au moins un échangeur thermique (19) est un échangeur thermique à plaques ou un échangeur thermique tubulaire.

7. Installation solaire thermique selon l'une quelconque des revendications 1 à 6, **caractérisée en ce que** sur le côté froid du thermogénérateur (20) est placé un dissipateur de chaleur à ailettes (23).

8. Installation solaire thermique selon l'une quelconque des revendications 5 à 7, **caractérisée en ce que** sur le côté chaud du thermogénérateur (20) est placé un absorbeur (27) destiné à absorber l'énergie du rayonnement solaire incident.

9. Installation solaire thermique selon l'une quelconque des revendications 1 à 8, **caractérisée en ce que** la commande par soupapes comprend au moins une soupape multivoies (17, 18, 28, 29).

10. Installation solaire thermique selon la revendication 9, **caractérisée en ce que** dans au moins une position de commutation de l'au moins une soupape multivoies (28, 17), le collecteur (2) peut être relié en deux parties avec l'au moins un échangeur thermique (19).

11. Installation solaire thermique selon l'une quelconque des revendications 1 à 9, **caractérisée en ce que** le circuit solaire (4) comporte une canalisation aller (7) et une canalisation retour (6) entre le collecteur (2) et un dissipateur thermique conçu sous la forme d'accumulateur de chaleur (5) et **en ce qu'**au moins une soupape continue qui permet un réglage du débit du milieu caloporteur du collecteur (2) vers le circuit solaire (4), ainsi que vers l'échangeur thermique (19) est montée dans la canalisation aller (7).

12. Installation solaire thermique selon la revendication 10 ou 11, **caractérisée en ce que** chaque soupape multivoies ou soupape continue peut être manoeuvrée électriquement et est reliée avec la commande de l'installation solaire.
